# EUROPÄISCHE PATENTANMELDUNG

(11) **EP 3 154 079 A1**
(43) Veröffentlichungstag der Anmeldung: **12.04.2017**
(21) Anmeldenummer: 15188966.4
(22) Anmeldetag: 08.10.2015
(51) Int. Cl.: H01L 21/60, H01L 21/683, H01L 23/488, H01L 21/48, H01L 23/373, H05K 3/32, H05K 3/34, H05K 3/36, H01L 23/14

(54) **VERFAHREN ZUM VERBINDEN EINER SUBSTRATANORDNUNG MIT EINEM ELEKTRONIKBAUTEIL MIT VERWENDUNG EINES AUF EINE KONTAKTIERUNGSMATERIALSCHICHT AUFGEBRACHTEN VORFIXIERMITTELS, ENTSPRECHENDE SUBSTRATANORDNUNG UND VERFAHREN ZU IHREM HERSTELLEN**

(71) Anmelder: Heraeus Deutschland GmbH & Co. KG, 63450 Hanau (DE)
(72) Erfinder: HINRICH, Andreas, 63579 Freigericht (DE); DUCH, Susanne, 63486 Bruchköbel (DE); MIRIC, Anton, 63755 Alzenau (DE); SCHÄFER, Michael, 36093 Künzell (DE)
(74) Vertreter: Kilchert, Jochen

(57) **Zusammenfassung**

Die Erfindung betrifft ein Verfahren zum Herstellen einer Substratanordnung (10, 10") zur Verbindung mit einem Elektronikbauteil (30), umfassend die Schritte:
- Bereitstellen eines Substrats (11) mit einer ersten Seite (12) und einer zweiten Seite (13),
- Aufbringen einer Kontaktierungsmaterial-Schicht (15) auf die erste Seite (12) des Substrats (11),
- zumindest abschnittsweises Aufbringen eines Vorfixiermittels (18) auf eine vom Substrat (11) abgewandte Seite (16) der Kontaktierungsmaterial-Schicht (15).

Die Erfindung betrifft auch eine entsprechende Substratanordnung (10, 10") sowie ein entsprechendes Verfahren zum Verbinden mindestens eines Elektronikbauteils (30) mit der Substratanordnung (10, 10").

Durch die erfindungsgemäßen Maßnahmen wird beim Transport vom Ort des Bestückens zum Ort des Verbindens eine ausreichende Transportfestigkeit erzeugt.

Die Kontaktierungsmaterial-Schicht (15) sollte vorzugsweise vollflächig, bzw. nahezu vollflächig, auf die erste Seite (12) des Substrates (11) aufgebracht werden. Das Substrat (11) mit aufgebrachter Kontaktierungsmaterial-Schicht (15) und aufgebrachtem Vorfixiermittel (18) kann lösbar auf einem Träger (20) positioniert werden. Die Substratanordnung (10, 10") wird beim Verbinden mit dem Elektronikbauteil (30, 30') mit diesem versintert, verpresst, verlötet und/oder verklebt. Das Substrat (11) kann ein Metallblech oder ein Metallbandabschnitt, insbesondere ein Kupferblech oder ein Kupferbandabschnitt, ein Leadframe, ein DCB-Substrat oder ein PCB-Substrat sein. Das Elektronikbauteil (30) kann ein Halbleiter, ein DCB-Substrat oder ein PCB-Substrat sein.

## Beschreibung

Die Erfindung bezieht sich auf ein Verfahren zum Herstellen einer Substratanordnung zur Verbindung mit einem Elektronikbauteil. Des Weiteren betrifft die Erfindung eine Substratanordnung zur Verbindung mit einem Elektronikbauteil. Außerdem betrifft die Erfindung ein Verfahren zum Verbinden eines Elektronikbauteils mit einer Substratanordnung.

In der Leistungselektronik ist es bekannt, Substrate oder Bauteile mit vorappliziertem Kontaktierungsmittel bereitzustellen wie z.B. vorgetrockneter Sinterpaste, Lot, Leitkleber. Innerhalb des Fertigungsprozesses beim Kunden können Bauteile, insbesondere Elektronikbauteile, die an ein Substrat mit vorappliziertem Kontaktierungsmittel, insbesondere mit vorgetrockneter Sinterpaste, angeheftet sind, beim Transport vom Ort des Bestückens zum Ort des Sinterns verrutschen.

Diesbezüglich ist es bekannt, dass die Bauteile, insbesondere Elektronikbauteile, auf die getrocknete Sinterpaste bei gleichzeitiger Wärmebeaufschlagung aufgesetzt werden. Es hat sich herausgestellt, dass ein derartiges warmes Bestücken bei einer Vielzahl von Elektronikbauteilen nur eine unzureichende Transportfestigkeit hervorruft, da die Adhäsion aufgrund gebogener Bauteile und/oder verschmutzter Oberflächen und/oder ungünstiger Oberflächengeometrien nicht ausreicht, um einen sicheren Transport vom Ort des Bestückens zum Ort des Sinterns zu ermöglichen, oder die Beschleunigungskräfte innerhalb des Transports sehr hoch sind. Daher ist es bekannt, die bestückten, aber noch nicht verlöteten bzw. versinterten oder verklebten Elektronikbauteile durch Masken oder Formen zu fixieren oder durch Federn aufwändig zu klemmen.

Ein weiterer Nachteil des bekannten Standes der Technik besteht darin, dass ein auf ein Substrat aufzutragendes Kontaktierungsmaterial oftmals unter Einhaltung von Abständen zum Bauteilrand, und/oder unter Bildung einer ungleichmäßigen, rampenartigen Struktur aufgebracht wird. Ein vollflächiges Beschichten mit einem Kontaktierungsmaterial ist gemäß bekannten Verfahren nicht bzw. nur sehr eingeschränkt möglich, da z.B. beim Aufsprühen von Sinterpaste spezielle Anforderungen an die Sinterpaste gestellt werden und das vollflächige Beschichten häufig mit hohen Sprühverlusten einhergeht.

Ausgehend von diesem Stand der Technik ist es Aufgabe der vorliegenden Erfindung, ein Verfahren zum Herstellen einer Substratanordnung zur Verbindung mit einem Elektronikbauteil anzugeben, so dass beim Transport vom Ort des Bestückens zum Ort des Sinterns der Elektronikbauteile eine ausreichende Transportfestigkeit erzeugt wird. Außerdem soll mit einem weiterentwickelten Verfahren eine möglichst große Fläche mit Kontaktierungsmaterial effizient beschichtbar bzw. herstellbar sein. Aus dieser Fläche sollen die Bauteile derart herausgetrennt werden, dass das Kontaktierungsmaterial allseitig möglichst bis zum Bauteilrand ragt.

Des Weiteren ist es Aufgabe der vorliegenden Erfindung, eine Substratanordnung zur Verbindung mit einem Elektronikbauteil anzugeben, wobei die Substratanordnung derart ausgebildet ist, dass ein bestücktes, aber noch nicht verlötetes bzw. versintertes oder verklebtes Bauteil auf der Substratanordnung eine ausreichende Transportfestigkeit aufweist. Außerdem ist eine Weiterentwicklung dahingehend durchzuführen, als dass die Substratanordnung eine große Fläche an Kontaktierungsmaterial aufweist.

Des Weiteren ist es eine Aufgabe der vorliegenden Erfindung, ein Verfahren zum Verbinden eines Elektronikbauteils mit einer Substratanordnung anzugeben.

Erfindungsgemäß wird die Aufgabe mit Blick auf das Verfahren zum Herstellen einer Substratanordnung zur Verbindung mit einem Elektronikbauteil durch den Gegenstand des Anspruches 1, mit Blick auf die Substratanordnung durch den Gegenstand des Anspruches 11 und mit Blick auf das Verfahren zum Verbinden eines Elektronikbauteils mit einer Substratanordnung durch den Gegenstand des Anspruches 16 gelöst.

Die Erfindung beruht auf dem Gedanken, ein Verfahren zum Herstellen einer Substratanordnung zur Verbindung mit einem Elektronikbauteil anzugeben, das folgende Schritte umfasst:
- Bereitstellen eines Substrats mit einer ersten Seite und einer zweiten Seite,
- Aufbringen einer Kontaktierungsmaterial-Schicht auf die erste Seite des Substrats,
- zumindest abschnittsweises Aufbringen eines Vorfixiermittels auf eine vom Substrat abgewandte Seite der Kontaktierungsmaterial-Schicht.

Die mit Hilfe des erfindungsgemäßen Verfahrens hergestellte Substratanordnung dient zur nachfolgenden Verbindung mit einem Elektronikbauteil.

Bei dem Substrat kann es sich um ein Metallblech oder um einen Metallbandabschnitt, insbesondere um ein Kupferblech oder um einen Kupferbandabschnitt, handeln. Des Weiteren ist es möglich, dass das Substrat ein Leadframe oder ein DCB-Substrat oder ein PCB-Substrat ist. Als Kupferblech ist auch ein Blech zu verstehen, das aus einem Kupferlegierungsmaterial besteht. Bei einem Kupferbandabschnitt kann es sich um einen derartigen Bandabschnitt handeln, der aus einem Kupferlegierungsmaterial besteht.

Vorzugsweise ist das Metallblech oder der Metallbandabschnitt, insbesondere das Kupferblech oder der Kupferbandabschnitt, nicht vorstrukturiert. Lediglich eine Ablängung und/oder Strukturierung der Seitenränder kann bei dem zu verwendenden Substrat durchgeführt worden sein.

Das bereitzustellende Substrat oder ein Substratrohling kann auf mindestens einer Seite, insbesondere mit einem Material, das Gold (Au) oder Nickel-Gold (NiAu) oder Silber (Ag) oder Nickel-Silber (NiAg) oder Nickel-Palladium-Gold (NiPdAu) umfasst, beschichtet, insbesondere galvanisiert sein. Außerdem ist es möglich, dass das Material auf mindestens einer Seite des Substrats oder des Substratrohlings chemisch abgeschieden wird.

Vorzugsweise wird das bereitzustellende Substrat oder ein Substratrohling, insbesondere mit den genannten Materialien, auf mindestens der Seite beschichtet, die später kontaktiert werden sollen. Außerdem ist es denkbar, dass beide Seiten des bereitzustellenden Substrates oder des Substratrohlings beispielsweise mit den vorgenannten Materialien beschichtet werden. In einer Ausführungsform der Erfindung ist es möglich, dass das Substrat vor dem Bereitstellen, insbesondere vor dem Beschichten von einem/dem Substratrohling abgetrennt wird. Bei dem Substratrohling kann es sich um ein Metallband oder Metallblech, insbesondere um ein Kupferband oder Kupferblech handeln. Es ist außerdem möglich, dass es sich bei dem Substratrohling um ein Band oder Blech aus einer Kupferlegierung handelt.

Es ist möglich, dass ein vollflächiges Metallband, insbesondere Kupferband, bereitgestellt und einseitig, endlos einseitig, insbesondere endlos einseitig, galvanisiert wird. Alternativ ist es möglich, dass das Substrat von dem Substratrohling, insbesondere von dem Metallband, insbesondere von dem Kupferband, abgetrennt wird und einzeln beispielsweise in einer Gestell-Galvanik, galvanisiert wird.

Auf die erste Seite des Substrates, bei der es sich beispielsweise um die beschichtete Seite oder um die der beschichteten Seite des Substrates gegenüberliegende Seite handeln kann, wird eine Kontaktierungsmaterial-Schicht aufgebracht. Die Kontaktierungsmaterial-Schicht sollte vorzugsweise vollflächig, bzw. nahezu vollflächig, auf die erste Seite des Substrates aufgebracht werden. Mindestens ein Substrat kann zum Aufbringen der Kontaktierungsmaterial-Schicht in einem Drucknest positioniert werden. Es ist möglich, dass mehrere Substrate in einem Drucknest positioniert werden. Des Weiteren ist es möglich, das Kontaktierungsmaterial zur Bildung einer Kontaktierungsmaterial-Schicht auf der ersten Seite des Substrates durch ein Sprühverfahren aufzubringen. Auch ein Rakelverfahren ist möglich.

Das Kontaktierungsmaterial, das eine Sinterpaste, insbesondere eine silberhaltige Sinterpaste, oder ein Lot oder ein Leitkleber oder eine Klebefolie ist, dient zum tatsächlichen Verbinden des Substrates mit dem Elektronikbauteil. Das Vorfixiermittel dient lediglich zur Vorfixierung bzw. zu einem vorübergehenden Anheften des Substrates an dem Elektronikbauteil oder des Elektronikbauteils an dem Substrat. Aufgrund des Vorfixierens bzw. Anheftens wird eine ausreichende Transportfähigkeit des Bauteils vom Ort des Bestückens zum Orte des Sinterns hervorgerufen. Das Vorfixiermittel ist ein temporäres Fixiermittel. Mit anderen Worten ist das Vorfixiermittel ein Fixiermittel, das eine vorübergehende Fixierung einer Substratanordnung bzw. eines Substrates mit einem Elektronikbauteil ermöglicht.

Das Vorfixiermittel wird zumindest abschnittsweise auf eine vom Substrat abgewandte Seite der Kontaktierungsmaterial-Schicht aufgebracht. Das Vorfixiermittel kann beispielsweise auf die Kontaktierungsmaterial-Schicht aufgestreut, aufgerieselt, aufgesprüht, dispenst, gejettet oder mit Hilfe eines Transferprozesses aufgebracht werden.

Da das Vorfixiermittel direkt auf der Kontaktierungsmaterial-Schicht aufgebracht ist, muss das Substrat nicht zusätzlich mit einem vorfixierten Mittel versehen werden. Mit anderen Worten muss kein Substratabschnitt zum Aufbringen eines Vorfixiermittels bereitgehalten bzw. von der Kontaktierungsmaterial-Schicht freigehalten werden. Dies führt zu einer Materialersparnis hinsichtlich des Substratmaterials. Die auf das Substrat aufgebrachte Kontaktierungsmaterial-Schicht kann eine Schichtdicke von 10 - 150 µm, insbesondere von 30 - 100 µm, insbesondere von 40 - 80 µm, aufweisen.

Die auf das Substrat aufgebrachte Kontaktierungsmaterial-Schicht und das auf die Kontaktierungsmaterial-Schicht aufgebrachte Vorfixiermittel werden nach dem Auftragen vorzugsweise getrocknet.

Das Substrat weist nach dem Aufbringen einer Kontaktierungsmaterial-Schicht vorzugsweise keinen seitlichen Rand auf. In diesem Fall ist das Substrat vollflächig mit einer Kontaktierungsmaterial-Schicht versehen. Außerdem ist es möglich, dass das Substrat einen seitlichen Rand aufweist, auf den keine Kontaktierungsmaterial-Schicht aufgetragen ist, wobei der Rand eine derartige Breite aufweist, die insbesondere höchstens 20% der Gesamtbreite des Substrats, insbesondere höchstens 10% der Gesamtbreite des Substrats, insbesondere höchstens 5% der Gesamtbreite des Substrats, insbesondere höchstens 1% der Gesamtbreite des Substrats, beträgt.

Beim Beschichten des Substrats mit einem Kontaktierungsmaterial bzw. bei Herstellung einer Kontaktierungsmaterial-Schicht auf dem Substrat wird also bereits in diesem Verfahrensstadium ein Substratadapter bzw. eine Substratanordnung mit möglichst wenig nicht-nutzbarem Rand produziert. Mit anderen Worten wird die erste Seite des Substrats mit möglichst viel Kontaktierungsmaterial versehen, so dass eine größtmögliche Kontaktierungsmaterial-Schicht entsteht.

Vorzugweise wird die auf das Substrat aufgebrachte Kontaktierungsmaterial-Schicht und das auf die Kontaktierungsmaterial-Schicht aufgebrachte Vorfixiermittel getrocknet. Mit anderen Worten wird das Substrat mit der aufgebrachten Kontaktierungsmaterial-Schicht und dem auf die Kontaktierungsmaterial-Schicht aufgebrachten Vorfixiermittel einem Trocknungsprozess ausgesetzt. Das Trocknen kann bei 80-150 °C Objekttemperatur für 2-30 min durchgeführt werden. Sofern ein Trocknen bzw. Vortrocknen durchgeführt wird, wird die Dicke des aufgebrachten Vorfixiermittels sowie die Dicke der aufgebrachten Kontaktierungsmaterial-Schicht aufgrund des Trocknens bzw. Vortrocknens reduziert.

In einer weiteren Ausführungsform der Erfindung kann das Substrat mit aufgebrachter Kontaktierungsmaterial-Schicht und aufgebrachtem Vorfixiermittel auf einem Träger derart positioniert werden, dass die erste Seite des Substrats dem Träger zugewandt angeordnet ist, wobei das Vorfixiermittel und ggf. zusätzlich die Kontaktierungsmaterial-Schicht mit dem Träger zumindest haftverbunden wird bzw. werden. Das Substrat kann folglich auf einem Träger aufgebracht werden, so dass die Substratanordnung, die ein Substrat, ein Vorfixiermittel, eine Kontaktierungsmaterial-Schicht und optional einen Träger umfasst, zu einer weiteren Produktionsstätte bzw. zu einer weiteren Verarbeitungsvorrichtung transportiert werden kann. Es ist möglich, dass lediglich das Vorfixiermittel mit dem Träger haftverbunden ist. Zwischen dem Träger und der Kontaktierungsmaterial-Schicht kann beispielsweise ein geringer Abstand bestehen.

Der Träger dient dazu, dass die Substratanordnung von einer ersten Produktionsstätte zu einer weiteren Produktionsstätte bzw. von einer ersten Fertigungsvorrichtung zu einer weiteren Fertigungsvorrichtung transportiert werden kann. Bei dem Träger kann es sich beispielsweise um eine Trägerfolie, insbesondere um eine Trägerfolie mit geringer Adhäsionskraft, handeln. Des Weiteren ist es möglich, zum Herstellen eines Trägers einen Wafer-Frame mit UV-Tape zu bespannen. Das mit einer Kontaktierungsmaterial-Schicht und dem Vorfixiermittel versehene Substrat kann auf dieses UV-Tape geklebt werden.

Gemäß einer bevorzugten Ausführungsform der Erfindung kann zumindest abschnittsweise ein/der seitliche(r) Rand des Substrats, vorzugsweise im mit dem Träger verbundenen Zustand, abgetrennt werden und/oder das Substrat, vorzugsweise im mit dem Träger verbundenen Zustand, strukturiert und/oder vereinzelt werden. Die Endteil-Geometrie, d.h. die endgültige Geometrie des Substratadapters bzw. der Substratanordnung kann demnach nach dem Aufbringen der Kontaktierungsmaterial-Schicht sowie des Vorfixiermittels, insbesondere im mit dem Träger verbundenen Zustand, hergestellt werden. Sofern zumindest abschnittsweise, vorzugsweise vollständig, ein/der seitliche(r) Rand des Substrats von der restlichen Substratanordnung bzw. vom restlichen Substratadapter abgetrennt wird, wird ein Substratadapter hergestellt, dessen Substrat vorzugsweise vollständig auf der ersten Seite mit einer Kontaktierungsmaterial-Schicht versehen ist bzw. auf der ersten Seite vollflächig eine Kontaktierungsmaterial-Schicht aufweist. Der nicht-nutzbare Rand der Substratanordnung bzw. des Substratadapters wird entfernt.

Des Weiteren ist es möglich, dass mehrere Substratanordnungen aus einer zunächst größeren Substratanordnung durch Vereinzeln hergestellt werden. Auch ein Strukturieren des Substrats, beispielsweise zur Anpassung des Substrats bzw. der Substratanordnung an die Geometrie des zu verbindenden Bauteils, ist möglich.

Vorzugsweise erfolgt das Abtrennen des seitlichen Rands und/oder das Strukturieren des Substrats und/oder das Vereinzeln des Substrats mittels Laser. Mit Hilfe eines Laserschneidverfahrens können äußerst kleine Bauteile bearbeitet werden. Des Weiteren können sehr scharfe Kanten mit Hilfe eines Laserschneidverfahrens erzeugt werden.

Beim Abtrennen des seitlichen Rands und/oder beim Strukturieren des Strukturieren des Substrats und/oder beim Vereinzeln des Substrats, insbesondere im mit dem Träger verbundenen Zustand des Substrats, kann bzw. können zumindest abschnittsweise die Kontaktierungsmaterial-Schicht und/oder das Vorfixiermittel abgetrennt und/oder strukturiert und/oder vereinzelt werden. Sofern die Kontaktierungsmaterial-Schicht abgetrennt und/oder strukturiert und/oder vereinzelt wird, können die durch beispielsweise Drucken der Kontaktierungsmaterial-Schicht entstehenden Rampen beseitigt werden. Außerdem ist es aufgrund der Laserbearbeitung der Kontaktierungsmaterial-Schicht möglich, möglichst ebene Kontaktierungsmaterial-Schichten zu erzeugen bzw. herzustellen.

Aufgrund des nachträglichen Laserschneidens bzw. Bearbeitens der Substratanordnung mittels Lasers wird eine freie Formgebung ermöglicht, so dass mittels des erfindungsgemäßen Verfahrens verschiedene Strukturen und Bauteilkombinationen hergestellt werden können. Auf ein Substrat mit den Abmaßen 200 mm x 200 mm kann beispielsweise eine Kontaktierungsmaterial-Schicht mit einer Grundfläche von etwa 180 mm x 180 mm bzw. 190 mm x 190 mm aufgebracht werden. Nach dem Abtrennen des seitlichen Rands ist somit die Herstellung eines Substratadapters mit den Abmaßen von maximal 190 mm x 190 mm möglich, wobei ein derartiges Substrat vollflächig mit einer Kontaktierungsmaterial-Schicht versehen ist.

Das Kontaktierungsmaterial der Kontaktierungsmaterial-Schicht umfasst vorzugsweise ein Sinterhilfsmittel und Metallpartikel, insbesondere Silberpartikel. Als Sinterhilfsmittel sind organische Verbindungen zu verstehen. Des Weiteren kann das Kontaktierungsmaterial Bindemittel und/oder Fettsäuren umfassen. Bei den Bindemitteln handelt es sich insbesondere um Polymere wie Zellulose-Derivate, beispielsweise Methylzellulose, Ethylzellulose, Ethylmethylzellulose, Carboxyzellullose und Hydroxypropylzellullose.

Bei den Fettsäuren kann es sich insbesondere um Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) handeln.

Der Begriff Sinterhilfsmittel umfasst demnach die im Kontaktierungsmaterial vorhandenen Fettsäuren und/oder Bindemittel und/oder organische Verbindungen. Vorzugsweise handelt es sich bei dem Kontaktierungsmaterial der Kontaktierungsmaterial-Schicht um eine Sinterpaste, insbesondere um eine Silber-Sinterpaste. Das Vorfixiermittel umfasst vorzugsweise das gleiche Sinterhilfsmittel. Metallpartikel, insbesondere Silberpartikel, sind vorzugsweise nicht im Vorfixiermittel enthalten.

Da das Kontaktierungsmaterial und das Vorfixiermittel vorzugsweise das gleiche Sinterhilfsmittel umfassen, kommt es bei einer Vorfixierung bzw. beim Aufbringen des Vorfixiermittels auf die Kontaktierungsmaterial-Schicht nicht zu einer Verunreinigung in der Kontaktierungsmaterial-Schicht in Form eines anderen Vorfixiermittels, wie z.B. Kleber. Unerwünschte Verunreinigungen im Zusammenhang mit der Kontaktierungsmaterial-Schicht werden demnach vermieden.

Die Erfindung beruht des Weiteren auf dem Gedanken, eine Substratanordnung zur Verbindung mit einem Elektronikbauteil anzugeben, wobei die Substratanordnung vorzugsweise mit einem vorerwähnten erfindungsgemäßen Verfahren hergestellt ist. Die erfindungsgemäße Substratanordnung umfasst ein Substrat, das insbesondere ein Metallblech oder einen Metallbandabschnitt, vorzugsweise ein Kupferblech oder einen Kupferbandabschnitt, oder ein Leadframe oder DCB-Substrat oder ein PCB-Substrat ist, mit einer ersten Seite und einer zweiten Seite, wobei auf der ersten Seite des Substrats zumindest abschnittsweise eine Kontaktierungsmaterial-Schicht aufgebracht ist, wobei auf einer vom Substrat abgewandten Seite der Kontaktierungsmaterial-Schicht zumindest abschnittsweise ein Vorfixiermittel aufgebracht ist.

In einer bevorzugten Ausführungsform der Erfindung ist die Kontaktierungsmaterial-Schicht vollflächig bzw. annähernd vollflächig auf der ersten Seite des Substrats aufgebracht.

Das Kontaktierungsmaterial der Kontaktierungsmaterial-Schicht umfasst Sinterhilfsmittel und Metallpartikel, insbesondere Silberpartikel. Das Vorfixiermittel umfasst in einer bevorzugten Ausführungsform der Erfindung das gleiche Sinterhilfsmittel. Als Sinterhilfsmittel sind die Fettsäuren und/oder Bindemittel und/oder organische Verbindungen zu verstehen, die in dem Kontaktierungsmaterial befindlich sind.

Bei den Bindemitteln handelt es sich insbesondere um Polymere wie ZelluloseDerivate, beispielsweise Methylzellulose, Ethylzellulose, Ethylmethylzellulose, Carboxyzellullose und Hydroxypropylzellullose.

Bei den Fettsäuren kann es sich insbesondere um Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) handeln.

Das Substrat ist auf mindestens einer Seite, insbesondere mit Material, das Gold (Au) oder Nickel-Gold (NiAu) oder Silber (Ag) oder Nickel-Silber (NiAg) oder Nickel-Palladium-Gold (NiPdAu) umfasst, beschichtet, insbesondere galvanisiert. Außerdem ist es möglich, dass das beschriebene Material auf mindestens einer Seite des Substrats chemisch abgeschieden wird.

In einer weiteren Ausführungsform weist die Substratanordnung einen Träger auf, der insbesondere als Trägerfolie ausgebildet ist, wobei der Träger mit dem Vorfixiermittel zumindest haftverbunden ist. Es ist möglich, dass auch das Kontaktierungsmaterial zumindest abschnittsweise mit dem Träger haftverbunden ist. Das Substrat ist in Relation zu dem Träger derart angeordnet, dass die erste Seite des Substrats dem Träger zugewandt angeordnet ist. Der Träger dient dazu, dass die Substratanordnung von einer ersten Produktionsstätte zu einer weiteren Produktionsstätte bzw. von einer ersten Fertigungsvorrichtung zu einer weiteren Fertigungsvorrichtung transportiert werden kann. Bei dem Träger kann es sich beispielsweise um eine Trägerfolie mit geringer Adhäsionskraft handeln. Des Weiteren ist es möglich, dass es sich bei dem Träger um ein UV-Tape handelt.

In einer besonders bevorzugten Ausführungsform der Erfindung weist das Substrat auf der ersten Seite vollflächig die Kontaktierungsmaterial-Schicht auf. In einer weiteren Ausführungsform der Erfindung ist es möglich, dass das Substrat einen seitlichen Rand aufweist, auf dem keine Kontaktierungsmaterial-Schicht aufgetragen ist, wobei der Rand eine derartige Breite aufweist, die insbesondere höchstens 20% der Gesamtbreite des Substrats, insbesondere höchstens 10% der Gesamtbreite des Substrats, insbesondere höchstens 5% der Gesamtbreite des Substrats, insbesondere höchstens 1% der Gesamtbreite des Substrats, beträgt.

Bezüglich des Aufbaus der Substratanordnung, insbesondere bezüglich des Vorteils der erfindungsgemäßen Substratanordnung wird auf die vorherigen Erläuterungen und Erklärungen im Zusammenhang mit dem erfindungsgemäßen Verfahren verwiesen.

Die Erfindung beruht des Weiteren auf dem Gedanken, ein Verfahren zum Verbinden eines Elektronikbauteils mit einer Substratanordnung anzugeben. Bei der Substratanordnung kann es sich insbesondere um eine erfindungsgemäße Substratanordnung und/oder um eine Substratanordnung, die mit Hilfe des beschriebenen erfindungsgemäßen Verfahrens hergestellt wurde, handeln. Das erfindungsgemäße Verfahren zum Verbinden eines Elektronikbauteils mit einer Substratanordnung umfasst die Schritte:
- Positionieren der Substratanordnung und des mindestens einen Elektronikbauteils zueinander derart, dass eine/die erste Seite eines/des Substrats dem Elektronikbauteil zugewandt angeordnet ist,
- Vorfixieren der Substratanordnung mit dem mindestens einen Elektronikbauteil durch ein/das auf einer Seite einer Kontaktierungsmaterial-Schicht zumindest abschnittsweise aufgebrachte(s) Vorfixiermittel,
- Verbinden der Substratanordnung mit dem mindestens einen Elektronikbauteil.

Das Positionieren der Substratanordnung und des Elektronikbauteils zueinander derart, dass eine/die erste Seite des Substrats dem Elektronikbauteil zugewandt angeordnet ist, kann zum einen derart ausgeführt werden, dass die Substratanordnung auf das Elektronikbauteil aufgesetzt wird. In einer weiteren Ausführungsform ist es denkbar, dass das Elektronikbauteil auf der Substratanordnung aufgebracht wird.

Sofern die Substratanordnung einen Träger umfasst bzw. auf einem Träger angeordnet ist, wird das Substrat zusammen mit der aufgebrachten Kontaktierungsmaterial-Schicht und dem aufgebrachten Vorfixiermittel, insbesondere vor dem Positionieren der Substratanordnung und des Elektronikbauteils zueinander, von einem/dem Träger gelöst.

Nach dem Positionieren der Substratanordnung und dem Elektronikbauteil zueinander wird vorzugsweise ein Vorfixieren der Substratanordnung mit dem Elektronikbauteil vorgenommen. Dieses Vorfixieren wird mit Hilfe des auf der ersten Seite des Substrates zumindest abschnittsweise aufgebrachten Vorfixiermittels durchgeführt. Hierzu erfolgt vorzugsweise eine Wärmebeaufschlagung. Vorzugsweise wird eine Temperatur von 100 - 150 °C aufgebracht, so dass das Vorfixiermittel über die aufgebrachte Wärme aktiviert wird und somit die Substratanordnung mit dem Elektronikbauteil vorfixiert werden kann. Aufgrund des Vorfixierens kann eine derartige Transportfestigkeit hinsichtlich des mit der Substratanordnung vorfixiert verbundenen Elektronikbauteils erzielt werden, dass das Elektronikbauteil nicht mehr aufgrund des Vorschubs eines Transportbandes losgeschüttelt werden kann. Vielmehr bleibt das Elektronikbauteil in der vorfixierten Lage.

Das Lösen des Substrats zusammen mit der aufgebrachten Kontaktierungsmaterial-Schicht und dem aufgebrachten Vorfixiermittel von einem/dem Träger kann mit Hilfe einer Düse erfolgen. Im Rahmen eines Pick-and-Place-Prozesses kann das Substrat zusammen mit der aufgebrachten Kontaktierungsmaterial-Schicht und dem aufgebrachten Vorfixiermittel auf einem Elektronikbauteil aufgebracht werden. Dies kann in einem Schritt erfolgen, d.h. nach dem Loslösen vom Träger kann das Substrat sofort auf dem Elektronikbauteil aufgesetzt werden. Des Weiteren ist es möglich, dass das Lösen des Substrats vom Träger und das Aufsetzen des Substrats zusammen mit der Kontaktierungsmaterial-Schicht und dem Vorfixiermittel auf dem Elektronikbauteil in zwei separaten Schritten durchgeführt wird.

Bei dem Elektronikbauteil kann es sich um einen Halbleiter oder ein DCB-Substrat oder ein PCB-Substrat handeln. Zeitlich nach dem Vorfixieren erfolgt das Verbinden der Substratanordnung mit dem Elektronikbauteil. Das Verbinden der Substratanordnung mit dem Elektronikbauteil kann beispielsweise mittels Versintern und/oder Verpressen und/oder Verlöten und/oder Verkleben erfolgen. Mit anderen Worten wird die Substratanordnung mit dem Elektronikbauteil versintert und/oder verpresst und/oder verlötet und/oder verklebt. Vorzugsweise wird die Substratanordnung mit dem Elektronikbauteil versintert. Hierzu weist die Substratanordnung die Kontaktierungsmaterial-Schicht, insbesondere in Form von Silber-Sinterpaste, auf.

Bezüglich des Vorfixiermittels im Zusammenhang mit dem erfindungsgemäßen Verfahren zum Verbinden eines Elektronikbauteils mit einer Substratanordnung wird auf die bereits aufgeführten Erläuterungen hinsichtlich des Vorfixiermittels verwiesen. Auch hinsichtlich der Anordnung des Vorfixiermittels und der Kontaktierungsmaterial-Schicht zueinander wird auf die bereits aufgeführten Erläuterungen verwiesen.

Vorzugsweise wird die mit dem Elektronikbauteil fixierte Substratanordnung zum Verbinden der Substratanordnung mit dem Elektronikbauteil in einem Prozessofen transportiert. Bei dem Prozessofen kann es sich beispielsweise um einen Drucksinterofen bzw. um eine Sinterpresse oder einen Reflow-Ofen oder einen Laminier-Ofen handeln.

Die Erfindung wird nachfolgend mit weiteren Einzelheiten unter Bezugnahme auf die beigefügten schematischen Zeichnungen anhand von Ausführungsbeispielen näher erläutert. In diesen zeigen:
- Fig. 1 - 5:: einzelne Schritte des Verfahrens zum Herstellen einer Substratanordnung;
- Fig. 6a - 8:: einzelne Schritte eines erfindungsgemäßen Verfahrens zum Verbinden eines Elektronikbauteils mit einer Substratanordnung gemäß einer ersten Ausführungsform; und
- Fig. 9 - 11:: einzelne Schritte eines erfindungsgemäßen Verfahrens zum Verbinden eines Elektronikbauteils mit einer Substratanordnung gemäß einer weiteren Ausführungsform.

Im Folgenden werden für gleiche und gleichwirkende Teile gleiche Bezugsziffern verwendet.

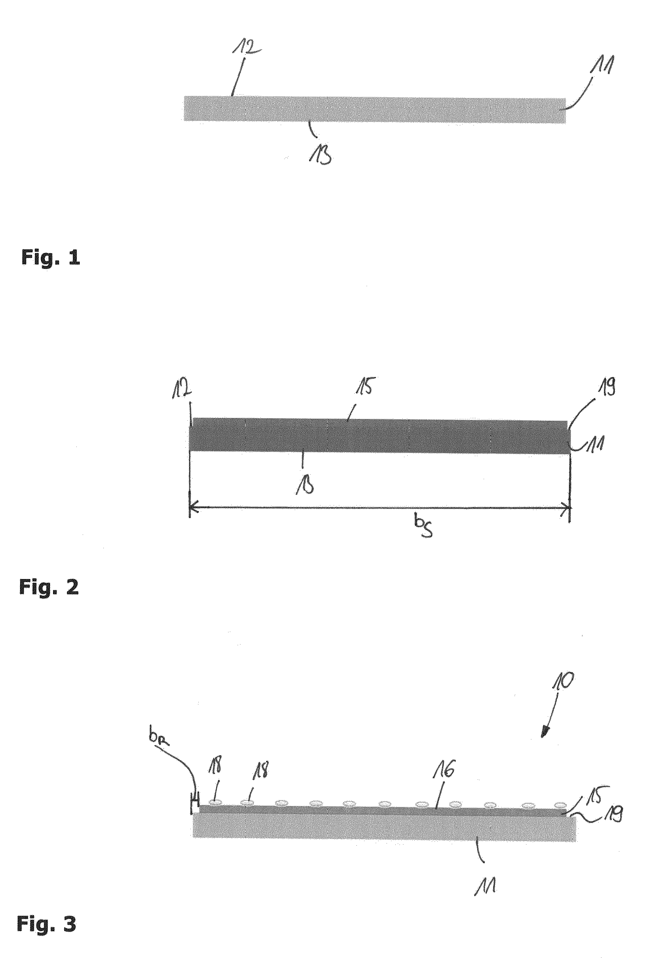

In Fig. 1 ist ein Substrat 11 dargestellt. Das Substrat 11 weist eine erste Seite 12 sowie eine zweite Seite 13 auf. Bei dem Substrat 11 handelt es sich vorzugsweise um einen Kupferbandabschnitt. Es ist auch möglich, dass Kupferlegierungsbandabschnitte verwendet werden.

Des Weiteren kann es vorgesehen sein, dass das Substrat 11 auf einer oder beiden Seiten 12 und 13 beschichtet ist. Vorzugsweise wird die erste Seite 12 und/oder die zweite Seite 13 mit Gold oder Nickel-Gold oder Silber oder Nickel-Silber oder Nickel-Palladium-Gold beschichtet, insbesondere galvanisiert.

Die erste Seite 12 des Substrates 11 ist im dargestellten Beispiel parallel zur gegenüberliegenden zweiten Seite 13 des Substrates 11 ausgebildet.

In Fig. 2 ist dargestellt, dass auf die Seite 12 des Substrates 10 ein Kontaktierungsmaterial zur Bildung einer Kontaktierungsmaterial-Schicht 15 aufgebracht ist. Bei dem Kontaktierungsmaterial der Kontaktierungsmaterial-Schicht 15 handelt es sich vorzugsweise um eine Sinterpaste, insbesondere um eine Silber-Sinterpaste. Eine Sinterpaste besteht üblicherweise aus Sinterhilfsmitteln und Metallpartikeln. Insbesondere handelt es sich bei den Metallpartikeln um Silberpartikel. Bei den Sinterhilfsmitteln handelt es sich um organische Verbindungen und/oder Fettsäuren und/oder Bindemitteln.

Die Kontaktierungsmaterial-Schicht 15 kann mit Hilfe eines Druckverfahrens auf die erste Seite 12 des Substrates 11 aufgetragen werden. Vorzugsweise wird auf die erste Seite 12 des Substrates 11 eine möglichst große flächige Kontaktierungsmaterial-Schicht 15 aufgetragen. Aufgrund der gewählten Auftrag-Technik, beispielsweise beim Druckverfahren, verbleiben allerdings schmale Ränder 19 auf dem Substrat 11 bzw. auf der ersten Seite 12 des Substrates 11, die keine Kontaktierungsmaterial-Schicht 15 aufweisen.

Der Rand 19 weist vorzugsweise eine derartige Breite b_{R} auf, die insbesondere höchstens 5% der Gesamtbreite b_{S} des Substrats 11 beträgt.

Wie in Fig. 3 dargestellt ist, wird auf die erste Seite 16 der Kontaktierungsmaterial-Schicht 15 ein Vorfixiermittel 18 aufgebracht. Die erste Seite 16 der Kontaktierungsmaterial-Schicht 15 ist die vom Substrat 11 bzw. von der ersten Seite 12 des Substrates 11 abgewandte Seite der Kontaktierungsmaterial-Schicht 15.

Das Vorfixiermittel 18 ist in Form von tropfenförmigen Elementen bzw. ellipsenförmigen Elementen auf diese erste Seite 16 der Kontaktierungsmaterial-Schicht aufgebracht. Das Vorfixiermittel 18 umfasst das gleiche Sinterhilfsmittel wie das Kontaktierungsmaterial der Kontaktierungsmaterial-Schicht 15. Aufgrund dessen werden beim Kontaktieren der Substratanordnung 10 mit einem Elektronikbauteil keine Verunreinigungen oder andersartige Materialien in die Kontaktierungsmaterial-Schicht 15 eingebracht.

Die Substratanordnung 10 umfasst gemäß Fig. 3 das Substrat 11, die Kontaktierungsmaterial-Schicht 15 sowie das Vorfixiermittel 18. Die auf das Substrat 11 aufgebrachte Kontaktierungsmaterial-Schicht 15 weist eine Schichtdicke von 40 - 80 µm auf.

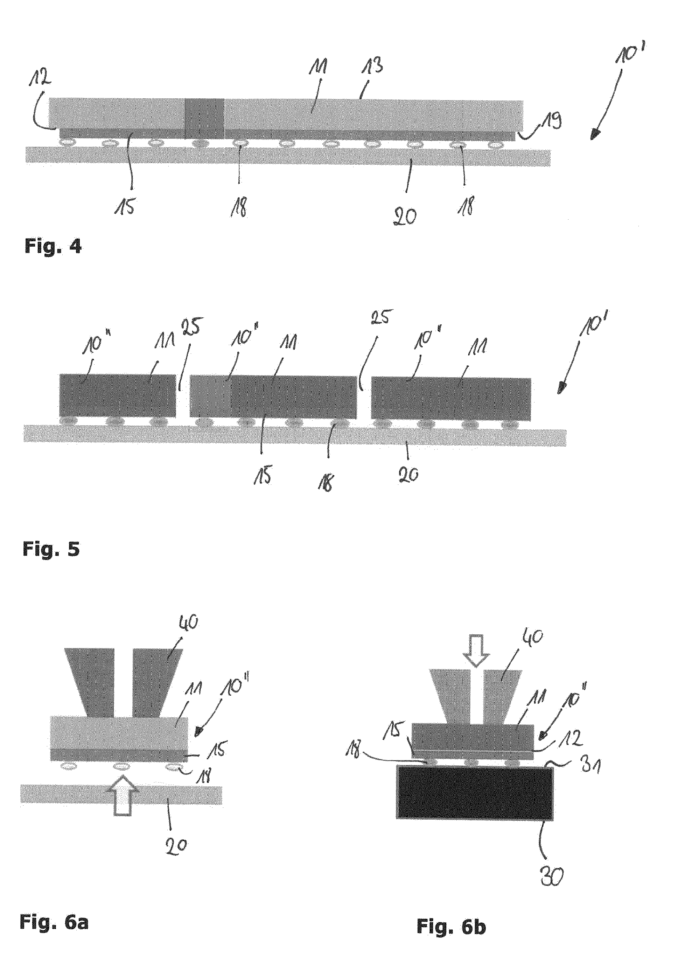

Wie in Fig. 4 dargestellt ist, wird das Substrat 11 mit aufgebrachter Kontaktierungsmaterial-Schicht 15 und aufgebrachtem Vorfixiermittel 18 auf einem Träger 20 derart positioniert, dass die erste Seite 12 des Substrats 11 dem Träger 20 zugewandt angeordnet ist, wobei das Vorfixiermittel 18 mit dem Träger 20 zumindest haftverbunden wird. Bei dem Träger 20 kann es sich um eine Trägerfolie handeln. Im dargestellten Beispiel ist ein Wafer-Frame mit einem UV-Tape bespannt, so dass das Substrat 11 zusammen mit der Kontaktierungsmaterial-Schicht 15 und dem Vorfixiermittel 18 auf diesem UV-Tape aufgebracht ist. Die Substratanordnung 10' umfasst in der Darstellung gemäß Fig. 4 somit den Träger 20, das Substrat 11 sowie die Kontaktierungsmaterial-Schicht 15 und das Vorfixiermittel 18.

In Fig. 5 ist dargestellt, dass die Substratanordnung 10' in eine gewünschte Endteil-Geometrie gebracht ist. Mit Hilfe eines Lasers sind beispielsweise die Ränder 19 entfernt. Des Weiteren ist das Substrat 11 im mit dem Träger 20 verbundenen Zustand vereinzelt. In das Substrat 10' sind Ausschnitte 25 eingebracht, so dass die Substratanordnung 10' in drei Einzel-Geometrien bzw. drei kleinere Substratanordnungen 10" unterteilt ist. Beim Abtrennen des seitlichen Rands 19 sowie beim Vereinzeln des Substrates 11 wurde zumindest abschnittsweise die Kontaktierungsmaterial-Schicht 15 und das Vorfixiermittel 18 ebenfalls abgetrennt bzw. strukturiert und vereinzelt.

Eine vereinzelte Substratanordnung 10" wird gemäß Darstellung der Fig. 6a von dem Träger 20 mit Hilfe einer Düse 40 gelöst. Bei der vereinzelten Substratanordnung 10" handelt es sich beispielsweise um die linke Substratanordnung 10" der Fig. 5. Die Haftverbindung zwischen dem Vorfixiermittel 18 und dem Träger 20 wird durch Aufbringen einer Zugkraft auf die Substratanordnung 10" gelöst, so dass die Substratanordnung 10" auf das Elektronikbauteil 30 wiederum mit Hilfe der Düse 40 aufgebracht werden kann. Die Substratanordnung 10" und das Elektronikbauteil 30 werden zueinander derart positioniert, dass die erste Seite 12 des Substrates 11 dem Elektronikbauteil 30 zugewandt angeordnet ist.

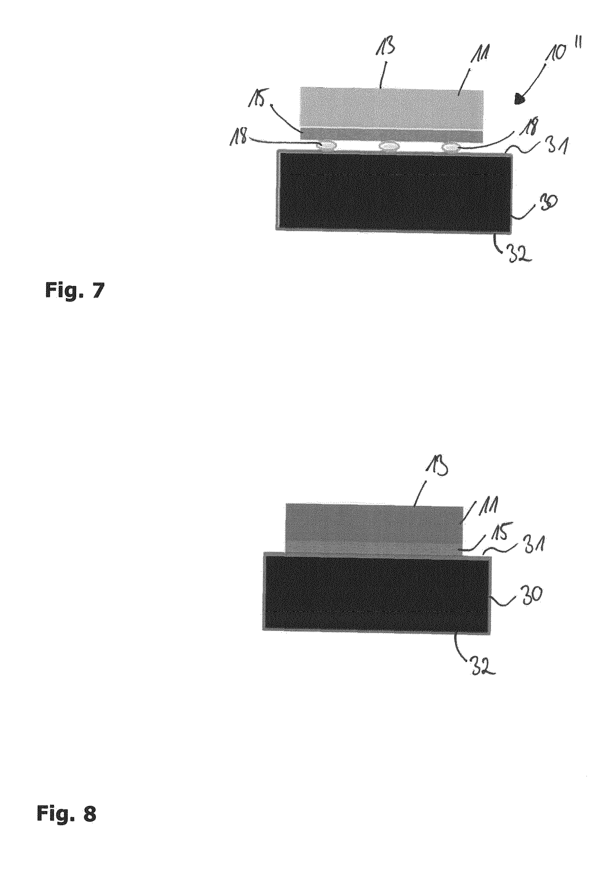

Es folgt gemäß Fig. 7 ein Vorfixieren der Substratanordnung 10" mit dem mindestens einen Elektronikbauteil 30 durch das auf der ersten Seite 16 der Kontaktierungsmaterial-Schicht 15 zumindest abschnittsweise aufgebrachte Vorfixiermittel 18. Die Substratanordnung 10" wird demnach mit Hilfe des Vorfixiermittels 18 auf der ersten Seite 31 des Elektronikbauteils 30 vorfixiert. Die Vorfixierung kann durch leichte Druckbeaufschlagung und/oder mittels Wärmebeaufschlagung erfolgen. Die zweite Seite 32 des Elektronikbauteils 30 ist im dargestellten Ausführungsbeispiel hingegen frei von weiteren Schichten und/oder Bauteilen.

In Fig. 8 ist das Elektronikbauteil 30 im mit der Substratanordnung verbundenen Zustand dargestellt. Das Vorfixiermittel 18 wird beim Verbinden der Substratanordnung 10" mit dem Elektronikbauteil 30, insbesondere beim Versintern und/oder Verpressen und/oder Verkleben aufgelöst. Zu erkennen ist lediglich die Kontaktierungsmaterial-Schicht 15. Da das Vorfixiermittel 18 das gleiche Sinterhilfsmittel wie das Kontaktierungsmaterial der Kontaktierungsmaterial-Schicht 15 umfasst, wird diese nicht verunreinigt. Mit anderen Worten ist nach der Prozessierung das Vorfixiermittel bzw. der Pre-Applied-Adhesive inaktiv und nicht mehr vorhanden.

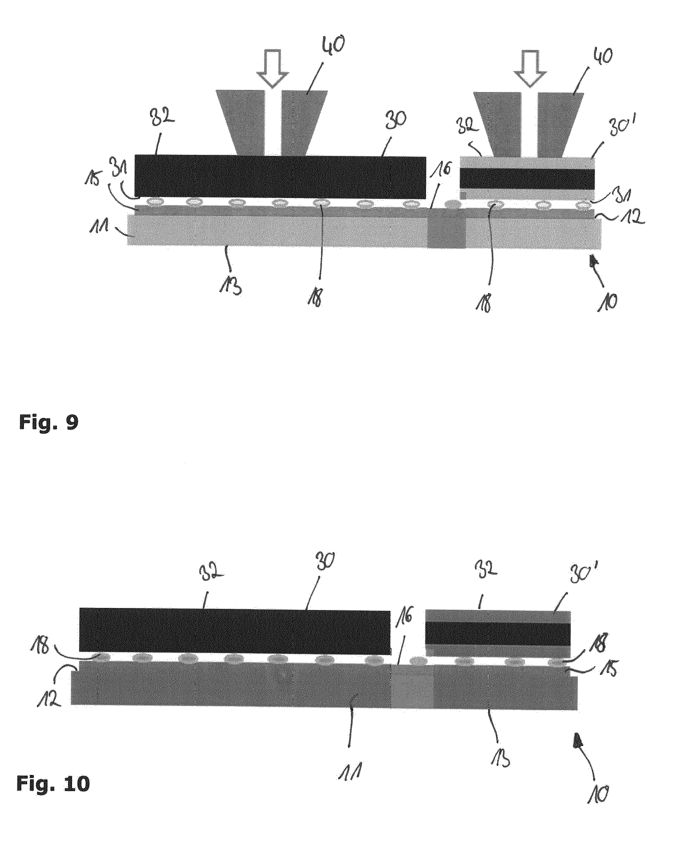

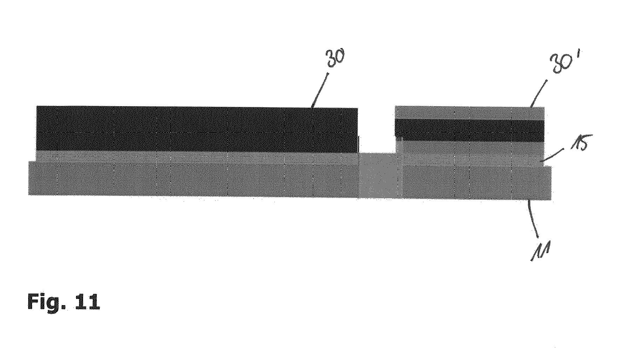

In den Fig. 9-11 ist eine zweite Ausführungsform hinsichtlich eines Verfahrens zum Verbinden mindestens eines Elektronikbauteils mit einer Substratanordnung 10 dargestellt. Den dargestellten Verfahrensschritten gehen typischerweise die in den Fig. 1-3 dargestellten Verfahrensschritte voraus, wobei das Substrat 13 auch ein Lead Frame, eine DCB oder eine PCB sein kann.

Demnach ist es möglich, auf einer Substratanordnung 10, die im dargestellten Beispiel keinen Träger umfasst, zwei Elektronikbauteile 30 und 30' aufzubringen. Das Aufbringen der Elektronikbauteile 30 und 30' erfolgt mittels Bestückprozess. Hierbei ist ein sogenannter Pick-and-Place-Prozess denkbar.

Im in Fig. 9 dargestellten Beispiel kann zusätzlich ein Wärmeeintrag erfolgen. Die Elektronikbauteile 30 und 30' sind jeweils mit den ersten Seiten 31 der Elektronikbauteile 30 und 30' zur ersten Seite 12 des Substrates 11 zugewandt positioniert, dass ein Vorfixieren der Elektronikbauteile 30 und 30' mit der Substratanordnung 10 durch das auf der ersten Seite 16 der Kontaktierungsmaterial-Schicht 15 Vorfixiermittel 18 erfolgen kann. Wie in Fig. 10 dargestellt ist, werden die Elektronikbauteile 30 und 30' durch das Vorfixiermittel 18 bzw. durch Pre-Applied-Adhesive zur weiteren Prozessierung gehalten.

Nach dem Vorfixieren erfolgt das eigentliche Verbinden der Substratanordnung 10 mit den Elektronikbauteilen 30 und 30'. Als Verbinden ist das Zusammenfügen der Substratanordnung 10 mit den Elektronikbauteilen 30 und 30' zu verstehen. Das Verbinden kann durch Löten oder Verpressen oder Versintern oder Verkleben erfolgen. Hierbei ist es denkbar, dass in einem Prozessofen, z.B. in einem Drucksinterofen bzw. in einer Drucksinterpresse oder Reflow-Ofen oder Laminier-Ofen die Substratanordnung 10 mit den Elektronikbauteilen 30 und 30' versintert wird. Beim Verbinden, vorzugsweise Versintern, wird das Vorfixiermittel 18 nahezu vollständig entfernt, insbesondere abgebrannt und/oder abgeschmolzen. Nach der Prozessierung ist der Pre-Applied-Adhesive inaktiv und nicht mehr vorhanden.

An dieser Stelle sei darauf hingewiesen, dass alle oben im Zusammenhang mit dem Ausführungsformen gemäß Fig. 1-11 beschriebenen Verfahrensschritte und Elemente für sich allein gesehen oder in jeder Kombination, insbesondere die in den Zeichnungen dargestellten Details, als erfindungswesentlich beansprucht werden.

### Bezugszeichenliste

- 10, 10', 10": Substratanordnung
- 11: Substrat
- 12: erste Seite
- 13: zweite Seite
- 15: Kontaktierungsmaterial-Schicht
- 16: erste Seite Kontaktierungsmaterial-Schicht
- 18: Vorfixiermittel
- 19: Rand
- 20: Träger
- 25: Ausschnitt
- 30, 30': Elektronikbauteil
- 31: erste Seite Elektronikbauteil
- 32: zweite Seite Elektronikbauteil
- 40: Düse
- bs: Gesamtbreite Substrat
- b_{R}: Breite Rand

## Patentansprüche

1. Verfahren zum Herstellen einer Substratanordnung (10; 10'; 10") zur Verbindung mit einem Elektronikbauteil (30; 30'), umfassend die Schritte:
- Bereitstellen eines Substrats (11) mit einer ersten Seite (12) und einer zweiten Seite (13),
- Aufbringen einer Kontaktierungsmaterial-Schicht (15) auf die erste Seite (12) des Substrats (11),
- zumindest abschnittsweises Aufbringen eines Vorfixiermittels (18) auf eine vom Substrat (11) abgewandte Seite (16) der Kontaktierungsmaterial-Schicht (15).

2. Verfahren nach Anspruch 1,
**dadurch gekennzeichnet, dass**
das Substrat (11) ein Metallblech oder ein Metallbandabschnitt, insbesondere ein Kupferblech oder ein Kupferbandabschnitt, oder ein Leadframe oder ein DCB-Substrat oder ein PCB-Substrat ist.

3. Verfahren nach Anspruch 1 oder 2,
**dadurch gekennzeichnet, dass**
das bereitzustellende Substrat (11) oder ein Substratrohling auf mindestens einer Seite (12; 13), insbesondere mit einem Material das Gold (Au) oder Nickel-Gold (NiAu) oder Silber (Ag) oder Nickel-Silber (NiAg) oder Nickel-Palladium-Gold (NiPdAu) umfasst, beschichtet, insbesondere galvanisiert oder chemisch abgeschieden, wird.

4. Verfahren nach einem der vorangegangenen Ansprüche,
**dadurch gekennzeichnet, dass**
die auf das Substrat (11) aufgebrachte Kontaktierungsmaterial-Schicht (15) eine Schichtdicke von 10 - 150 µm, insbesondere von 30 - 100 µm, insbesondere von 40 - 80 µm, aufweist.

5. Verfahren nach einem der vorangegangenen Ansprüche,
**dadurch gekennzeichnet, dass**
das Substrat (11) nach dem Aufbringen einer Kontaktierungsmaterial-Schicht (15) keinen seitlichen Rand aufweist oder einen seitlichen Rand (19) aufweist, auf dem keine Kontaktierungsmaterial-Schicht (15) aufgetragen ist, wobei der Rand (19) eine derartige Breite (b_{R}) aufweist, die insbesondere höchstens 20 % der Gesamtbreite (b_{S}) des Substrats (11), insbesondere höchstens 10 % der Gesamtbreite (b_{S}) des Substrats (11), insbesondere höchstens 5 % der Gesamtbreite (b_{S}) des Substrats (11), insbesondere höchstens 1% der Gesamtbreite (b_{S}) des Substrats (11), beträgt.

6. Verfahren nach einem der vorangegangenen Ansprüche,
**gekennzeichnet durch**
Positionieren des Substrats (11) mit aufgebrachter Kontaktierungsmaterial-Schicht (15) und aufgebrachtem Vorfixiermittel (18) auf einem Träger (20), insbesondere einer Trägerfolie, derart, dass die erste Seite (12) des Substrats (11) dem Träger (20) zugewandt angeordnet ist, wobei das Vorfixiermittel (18) mit dem Träger (20) zumindest haftverbunden wird.

7. Verfahren nach einem der vorangegangenen Ansprüche, insbesondere nach Anspruch 6,
**dadurch gekennzeichnet, dass**
zumindest abschnittsweise ein/der seitliche(r) Rand (19) des Substrats (11), vorzugsweise im mit dem Träger (20) verbundenen Zustand, abgetrennt wird und/oder das Substrat (11), vorzugsweise im mit dem Träger (20) verbundenen Zustand, strukturiert und/oder vereinzelt wird.

8. Verfahren nach Anspruch 7,
**dadurch gekennzeichnet, dass**
das Abtrennen des seitlichen Rands (19) und/oder das Strukturieren des Substrats (11) und/oder das Vereinzeln des Substrats (11) mittels Lasers erfolgt.

9. Verfahren nach Anspruch 7 oder 8,
**dadurch gekennzeichnet, dass**
beim Abtrennen des seitlichen Rands (19) und/oder beim Strukturieren des Substrats (11) und/oder beim Vereinzeln des Substrats (11) zumindest abschnittsweise die Kontaktierungsmaterial-Schicht (15) und/oder das Vorfixiermittel (18) abgetrennt und/oder strukturiert und/oder vereinzelt wird.

10. Verfahren nach einem der vorangegangenen Ansprüche,
**dadurch gekennzeichnet, dass**
das Kontaktierungsmaterial der Kontaktierungsmaterial-Schicht (15) Sinterhilfsmittel und Metallpartikel, insbesondere Silberpartikel, umfasst, wobei das Vorfixiermittel (18) das gleiche Sinterhilfsmittel umfasst.

11. Substratanordnung (10; 10'; 10") zur Verbindung mit einem Elektronikbauteil (30; 30'), insbesondere hergestellt nach einem der Ansprüche 1 bis 10, umfassend ein Substrat (11), das insbesondere ein Metallblech oder ein Metallbandabschnitt, vorzugsweise ein Kupferblech oder ein Kupferbandabschnitt, oder ein Leadframe oder ein DCB-Substrat oder ein PCB-Substrat ist, mit einer ersten Seite (12) und einer zweiten Seite (13), wobei auf der ersten Seite (12) des Substrats (11) zumindest abschnittsweise eine Kontaktierungsmaterial-Schicht (15) aufgebracht ist, wobei auf einer vom Substrat (11) abgewandten Seite (16) der Kontaktierungsmaterial-Schicht (15) zumindest abschnittsweise ein Vorfixiermittel (18) aufgebracht ist.

12. Substratanordnung (10; 10'; 10") nach Anspruch 11,
**dadurch gekennzeichnet, dass**
das Kontaktierungsmaterial der Kontaktierungsmaterial-Schicht (15) Sinterhilfsmittel und Metallpartikel, insbesondere Silberpartikel, umfasst, wobei das Vorfixiermittel (18) das gleiche Sinterhilfsmittel umfasst.

13. Substratanordnung (10; 10'; 10") nach Anspruch 11 oder 12,
**dadurch gekennzeichnet, dass**
das Substrat (11) auf mindestens einer Seite (12; 13), insbesondere mit Material, das Gold (Au) oder Nickel-Gold (NiAu) oder Silber (Ag) oder Nickel-Silber (NiAg) oder Nickel-Palladium-Gold (NiPdAu) umfasst, beschichtet, insbesondere galvanisiert oder chemisch abgeschieden, ist.

14. Substratanordnung (10; 10'; 10") nach einem der Ansprüche 11 bis 13,
**gekennzeichnet durch**
einen Träger (20), der insbesondere als Trägerfolie ausgebildet ist, wobei der Träger (20) mit dem Vorfixiermittel (18) zumindest haftverbunden ist.

15. Substratanordnung (10; 10'; 10") nach einem der Ansprüche 11 bis 14,
**dadurch gekennzeichnet, dass**
das Substrat (11) auf der ersten Seite (12) vollflächig eine Kontaktierungsmaterial-Schicht (15) aufweist oder einen seitlichen Rand (19) aufweist, auf dem keine Kontaktierungsmaterial-Schicht (15) aufgetragen ist, wobei der Rand (19) eine derartige Breite (b_{R}) aufweist, die insbesondere höchstens 20 % der Gesamtbreite (b_{S}) des Substrats (11), insbesondere höchstens 10 % der Gesamtbreite (b_{S}) des Substrats (11), insbesondere höchstens 5 % der Gesamtbreite (b_{S}) des Substrats (11), insbesondere höchstens 1% der Gesamtbreite (b_{S}) des Substrats (11), beträgt.

16. Verfahren zum Verbinden mindestens eines Elektronikbauteils (30; 30') mit einer Substratanordung (10; 10'; 10"), insbesondere mit einer Substratanordnung (10; 10'; 10") nach einem der Ansprüche 11 bis 15 und/oder mit einer Substratanordnung (10; 10'; 10"), die nach einem Verfahren nach einem der Ansprüche 1 bis 10 hergestellt ist, umfassend die Schritte:
- Positionieren der Substratanordnung (10; 10'; 10") und des mindestens einen Elektronikbauteils (30; 30') zueinander derart, dass eine/die erste Seite (12) eines/des Substrats (11) dem Elektronikbauteil (30; 30') zugewandt angeordnet ist,
- Vorfixieren der Substratanordnung (10; 10'; 10") mit dem mindestens einen Elektronikbauteil (30; 30') durch ein/das auf einer Seite (16) einer Kontaktierungsmaterial-Schicht (15) zumindest abschnittsweise aufgebrachte(s) Vorfixiermittel (18),
- Verbinden der Substratanordnung (10; 10') mit dem mindestens einen Elektronikbauteil (30; 30').

17. Verfahren nach Anspruch 16,
**dadurch gekennzeichnet, dass**
das Substrat (11) zusammen mit der aufgebrachten Kontaktierungsmaterial-Schicht (15) und dem aufgebrachten Vorfixiermittel (18), insbesondere vor dem Positionieren der Substratanordnung (10; 10'; 10") und des Elektronikbauteils (30; 30') zueinander, von einem/dem Träger (20) gelöst wird.

18. Verfahren nach Anspruch 16 oder 17,
**dadurch gekennzeichnet, dass**
die Substratanordnung (10; 10'; 10") beim Verbinden mit mindestens einen Elektronikbauteil (30, 30') mit diesem versintert und/oder verpresst und/oder verlötet und/oder verklebt wird.
